# EUROPEAN PATENT SPECIFICATION

(11) **EP 0 397 304 B1**
(45) Date of publication and mention of the grant of the patent: **31.08.1994**
(21) Application number: 90302758.9
(22) Date of filing: 15.03.1990
(51) Int. Cl.: G02F 1/1345, H01R 4/04, H05K 3/32

(54) **Method and structure for wiring connection of a display device**
Verfahren und Anordnung zur Leitungsverbindung für eine Anzeigevorrichtung
Procédé et structure de raccordement de conduite pour un dispositif d'affichage

(30) Priority: 15.03.1989 JP 64161/89
(43) Date of publication of application: 14.11.1990
(73) Proprietor: SHARP KABUSHIKI KAISHA, Osaka 545 (JP)
(72) Inventor: Obata, Masao, Nara-shi, Nara-ken (JP); Arima, Masaki, Yamatokoriyama-shi, Nara-ken (JP); Taniguchi, Kouki, Osaka-shi, Osaka-fu (JP)
(74) Representative: Brown, Kenneth Richard

(56) References cited:
- EP-A- 0 110 382
- EP-A- 0 140 619
- EP-A- 0 267 688
- US-A- 4 295 711
- US-A- 4 640 581

## Description

The present invention relates to a method and structure for wiring connection of a display device such as a liquid crystal display device.

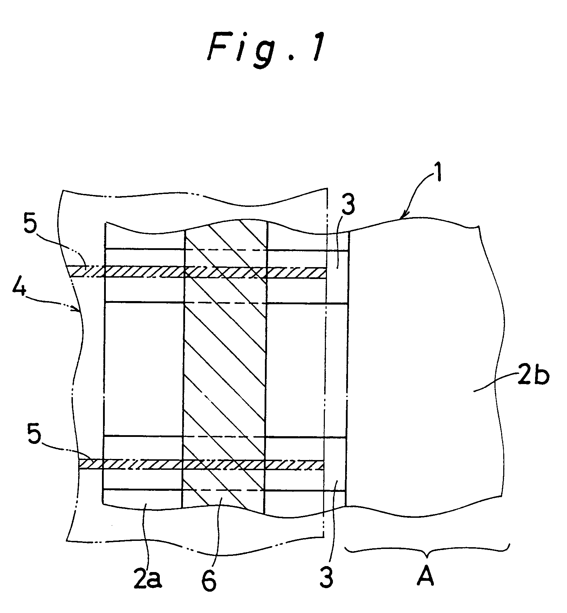

Fig. 1 is a partially enlarged plan view showing a wiring connection structure in which an electrode 5 formed on such a film-like printed circuit substrate 4 as a tape carrier (tape automated bonding, hereinafter merely called "TAB") and a flexible printed circuit substrate (hereinafter merely called "FPC") is connected to another electrode 3 formed on a substrate 2a at the side of a display cell 1 of a liquid crystal display device.

In Fig. 1, the electrode 3 on one substrate 2a which is so formed as to be partially overhung from the display area A of the display cell 1 is, for example, a common electrode, and a segment electrode (not illustrated) is formed on another substrate 2b so arranged as to confront, through a liquid crystal layer (not illustrated), the substrate 2a. An anisotropic conductive film 6 is so adhered to the intermediate position on the surface of the portion of the substrate 2a overhung from the display area A that it lies across the electrode 3. The film-like printed circuit substrate 4 is so laminated as to secure matching between the electrode 5 and the electrode 3. That is, the electrode 3 at the side of the substrate 2a and the electrode 5 at the side of the film-like printed circuit substrate 4 are electrically connected by way of the anisotropic conductive film 6. This anisotropic conductive film 6 is a conductive film which can permit the conductivity only in the vertical direction in Fig. 1. Therefore, the adjacent electrodes 3 and 5 are never short-circuited through this anisotropic conductive film 6.

In such a wiring connection structure, if the film-like printed circuit substrate 4 is once peeled off from the substrate 2a at the side of the display cell 1 in order to correct for positional error or to carry out repair, because of, for example, wire break or current leakage, the electrode 3 on the substrate 2a at the side of the display cell 1 is likely to be peeled off. Especially, if the electrode 3 is not directly formed on the substrate 2a but rather the electrode 3 is formed on an overcoat film comprising resin to shield the colour filter in the case of a colour liquid crystal display device, the electrode 3 is much more likely to be peeled off.

For this reason, even though the electrode 5 of the film-like printed circuit substrate 4 may be reconnected to the electrode 3 of the substrate 2a at the side of the display cell 1 after correcting the positional error or repairing such a fault as wire break, the reliability of the connected portion may be remarkably lowered. Conventionally, re-connection has not been carried out.

Actually however, substrates in which positional error or wire break occurs in the connected portions thereof as in the conventional examples are disposed of as defective; the ratio of completeness of the products is thus remarkably lowered, causing the cost of production to be much increased.

From US-A-4,640,581, it is known to connect a flexible printed circuit board to a terminal section of a display device by carrying out a soldering operation.

It is therefore an object of the invention to provide a method and structure for wiring connection of a display device by which an electrode of a substrate at the side of a display cell can be reconnected to another electrode of a film-like printed circuit substrate without spoiling the reliability of connection therebetween.

In one aspect, the invention provides a method of wiring connection of a display device in which an array of first electrodes formed on a display substrate of said display device are connected to a corresponding array of second electrodes formed on a wiring substrate by performing a procedure involving positioning the substrates with their said arrays confronting one another and bringing the substrates together to interconnect the respective first and second electrodes thereof, characterized in that the electrode connection position on the display substrate is spaced from the edge of a display section of the display substrate by a space which is sufficient to permit, if necessary, re-connection of the first and second electrodes in the same manner at a different electrode connection position on the display substrate in said space.

The present invention thus solves the problem of the tendency of the display substrate electrodes to be peeled off, by performing the initial connection at a position suitably removed from the edge of the display area. In this way, there is reserved a part of the display substrate having the electrodes intact for making a new connection, if necessary.

When an abnormal connection is formed at the initial electrode connection position, the substrates previously brought together may be separated. The substrates may then be brought together again to form a new connection at said different electrode connection position.

In another aspect, the invention provides a display device in which an array of first electrodes formed on a display substrate of the display device are connected to a corresponding array of second electrodes formed on a wiring substrate confronting a portion of the display substrate, characterized in that the electrode connection position on the display substrate is spaced from the edge of a display section of the display substrate by a space which is sufficient to permit, if necessary, re-connection of the first and second electrodes at a different electrode connection position on the display substrate in said space.

There may be formed on the display substrate, or its associated electrodes, a sign indicating said different electrode connection position.

According to a preferred embodiment of both aspects of the invention, the first and second electrodes are interconnected through intermediary anisotropic conductive material.

According to a preferred embodiment of both aspects of the invention, the array of second electrodes are distributed among a plurality of said wiring substrates which are individually attachable to the display substrate.

According to the invention, in the case that any positional error, wire break or current leakage should occur between the first electrodes and the second electrodes when one or more wiring substrates are connected to the display substrate, the wiring substrate affected by the abnormality can be separated from the display substrate. At this time, the first electrodes formed on the display substrate may be peeled off. However, thereafter, a connection position which is different from the previous connection position can be used. Therefore, for instance, even though a previously connected portion of the first electrode may have become peeled off, the second electrode can be normally connected to another portion that is not peeled off, in subsequent connection.

Thus, according to the method for wiring connection of the display device of the invention, as a repeated connection can be effected at a position different from that of the previously connected portion, an electrode of a film-like printed circuit substrate can be electrically connected to a portion which is not peeled off of the electrode on the display substrate at the side of the display cell in subsequent connections. So, the reliability of the connected portion is not lowered at all even in subsequent connections. Therefore, it becomes possible to repair the connected points, thereby causing the ratio of completeness of the products to be much heightened.

An embodiment of the invention will now be described, by way of example only, with reference to the accompanying drawings, in which:
Fig. 1 is a plan view showing an enlarged part of a liquid crystal display device for explanation of a conventional method for wiring connection;
Fig. 2 is a plan view showing the outline of the composition of a colour liquid crystal display device to which a method for wiring connection according to a preferred embodiment of the invention can be applied;
Fig. 3 is a sectional view taken along line III - III of Fig. 2; and
Fig. 4 is an enlarged plan view showing a part marked "IV" in Fig. 2.

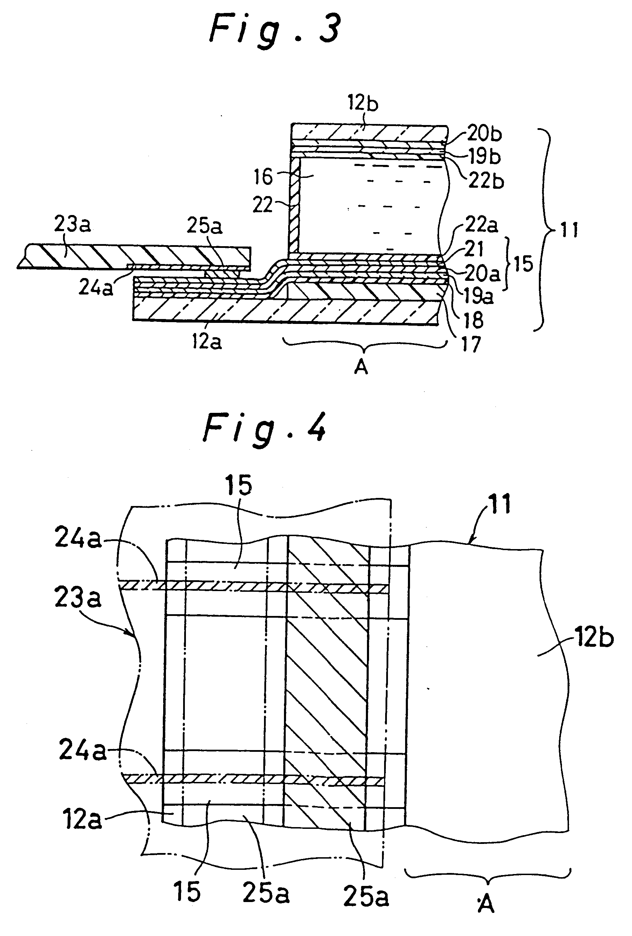

As shown in Fig. 3, the display cell 11 of a colour liquid crystal display device comprises a pair of glass substrates 12a and 12b which confront each other through a liquid crystal layer 16. A colour filter 17 is provided on one of the glass substrates 12a, and the colour filter 17 is shielded by an overcoat film 18 consisting of resin. An oxidization film 19a, such as SiO₂, is formed on the overcoat film 18. A transparent electrode 20a consisting of ITO (indium tin oxide) film, etc. is formed on this oxidization film 19a, and further a Mo (molybdenum) electrode 21 is formed over the transparent electrode 20a, thereby causing a common electrode 15 to be constituted. A plurality of the common electrodes 15 are so formed as to be arranged in parallel with each other on the glass substrate 12a. Then, in the display area A in which the above pair of glass substrates 12a and 12b overlap one another, an orientation film 22a is formed on the front surface of the common electrodes 15.

A plurality of the transparent electrodes 20b which constitute segment electrodes are formed on the glass substrate 12b in parallel with each other extending in such a direction that they intersect at a right angle the common electrodes 15. An oxidization film 19b, such as SiO₂, is formed on the transparent electrode 20b, and an orientation film 22b is also formed on the oxidization film 19b. A liquid crystal layer 16 is interposed between the orientation film 22a on the glass substrate 12a and the orientation film 22b on the glass substrate 12b and is sealed by means of a sealing member 22.

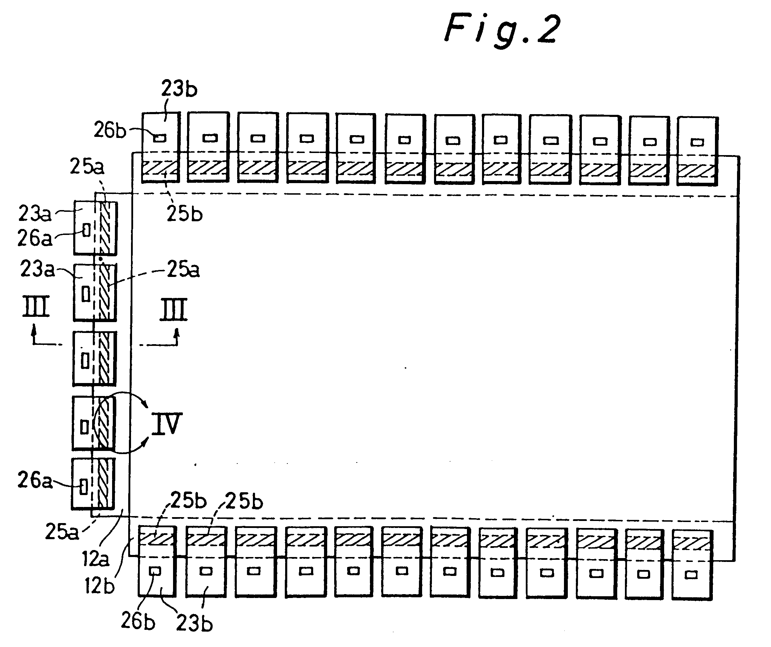

The common electrode 15 is formed also on the portion of the glass substrate 12a which extends beyond (i.e. overhangs at) the periphery of the display area A (in the horizontal direction of Fig. 2). The segment electrode 20b is formed also on the portion of the glass substrate 12b which extends beyond (i.e. overhangs at) the periphery of the display area A (in the vertical direction of Fig. 2).

Electrodes 24a formed on a set of such film-like printed circuit substrates 23a as the aforementioned TAB and FPC types are connected by way of an anisotropic conductive film 25a to the common electrodes 15 on the portion of the glass substrate 12a which extends beyond the display area A of the cell 11. Chips 26a of integrated circuit (hereinafter merely called "IC"), internally having peripheral circuits by which the common electrodes 15 corresponding to the display cells 11 are driven, are mounted as shown in Fig. 2. These IC chips 26a are connected to the common electrodes 15 of the display cell 11 by way of the electrodes 24a and the anisotropic conductive films 25a.

The anisotropic conductive film 25a may be such that thin conductor lines are built in, for instance, rubber in parallel with the direction of thickness, or may be such that thin metal particles are uniformly buried in resin and respective metal particles are insulated from each other.

Fig. 4 shows a structure of connection between the electrodes 24a of the film-like printed circuit substrate 23a and the common electrodes 15 on the glass substrate 12a. The anisotropic conductive film 25a is so located that it can be intercrossed with the common electrodes 15 and is adhered thereon. In the first wiring and connection, the position of attachment of the anisotropic conductive film 25a is set at the edge side of the glass substrate 12a, that is, remotely apart from the display area A, as shown with a one-dashed line in Fig. 4. The film-like printed circuit substrate 23a is so overlapped on the glass substrate 12a that the electrodes 24a thereof can be matched to the corresponding common electrodes 15, thereby causing the electrodes 15 and 24a to be connected by means of the anisotropic conductive film 25a. The anisotropic conductive film 25a can permit the conductivity only in the vertical direction of Fig. 4. Therefore, it is common to the prior art that the adjacent electrodes 15 and the adjacent electrodes 24a are not short-circuited. In this case, at least such a spacer as to adhere another anisotropic conductive film 25a is secured between the attachment position of the anisotropic conductive film 25a and the edge of the display area A in the first wiring and connection.

Referring to Fig. 2, electrodes formed on another set of film-like printed circuit substrates 23b are connected through an anisotropic conductive film 25b to the transparent segment electrodes 20b on the glass substrate 12b. IC chips 26b, internally having peripheral circuits by which the segment electrodes 20b corresponding to the display cells 11 are driven, are mounted on the film-like printed circuit substrates 23b.

In the case that any positional error should occur at the connections of the electrodes 15 and 24a as shown in Fig. 4, or in the case that it is detected in the inspection process that wire break or current leakage occurs at the connections thereof, the film-like printed circuit substrate 23a is peeled off once from the connections thereof, the positional error is corrected and/or the wire break or current leakage is repaired, and the electrodes 15 and 24a are connected again by way of an anisotropic conductive film 25a. At this time, the attachment position of the anisotropic conductive film 25a on the common electrodes 15 is set to a position (shown with the oblique lines in Fig. 4) closer toward the display area A, thereby avoiding the previous connected portion. The setting of a different position, distinguishing the attachment position of the anisotropic conductive film 25a in the first connection from that of the subsequent connection, may be effected by adding a sign at each attachment position to the glass substrate 12a or by forming a part of a sign showing the attachment positions on the pattern of the common electrodes 15.

In a subsequent connection, even if the common electrode 15 should become peeled off from the glass substrate 12a at the connected portion when having peeled off the film-like printed circuit substrate 23a therefrom, in the case that the electrodes 15 and 24a are connected avoiding the previously connected portion as mentioned above, a subsequent connection can be effected avoiding the peeled off portion. Therefore, the reliability of the connected portions will never be lowered as a result of the first peel-off of the film-like printed circuit substrate 23a.

The above connection method can be effected also between the segment electrodes (transparent electrodes) 20b and the electrodes of the other film-like printed circuit substrates 23b.

Also, the preferred embodiment has been described in detail, in relation to the case of a liquid crystal display device. The method of the invention can be applied also to other display devices.

The invention can be effected in other various modifications and variations without departing from the scope thereof. Therefore, the above mentioned preferred embodiment is merely an example in every aspect.

## Claims

1. A method of wiring connection of a display device in which an array of first electrodes (15;20b) formed on a display substrate (12a;12b) of said display device are connected to a corresponding array of second electrodes (24a) formed on a wiring substrate (23a;23b) by performing a procedure involving positioning the substrates (12a,23a;12b,23b) with their said arrays confronting one another and bringing the substrates (12a,23a) together to interconnect the respective first and second electrodes (15,24a) thereof, characterized in that the electrode connection position on the display substrate (12a) is spaced from the edge of a display section (A) of the display substrate (12a) by a space which is sufficient to permit, if necessary, re-connection of the first and second electrodes in the same manner at a different electrode connection position on the display substrate in said space.

2. The method of claim 1, in which the substrates (12a, 23a) previously brought together are separated because of an abnormal connection formed at the initial electrode connection position on the display substrate (12a), and the substrates (12a,23a) are subsequently brought together again to interconnect the respective first and second electrodes (15,24a) thereof at said different electrode connection position on the display substrate (12a).

3. The method of claim 1 or claim 2, wherein the arrays of first (15;20b) and second (24a) electrodes are interconnected through intermediary anisotropic conductive material (25a;25b).

4. The method of any one of claims 1 to 3, wherein said array of second electrodes (24a) are distributed among a plurality of said wiring substrates (23a;23b) which are individually attachable to said display substrate (12a;12b).

5. A display device in which an array of first electrodes (15;20b) formed on a display substrate (12a;12b) of the display device are connected to a corresponding array of second electrodes (24a) formed on a wiring substrate (23a;23b) confronting a portion of the display substrate, characterized in that the electrode connection position on the display substrate (12a) is spaced from the edge of a display section (A) of the display substrate (12a) by a space which is sufficient to permit, if necessary, re-connection of the first and second electrodes at a different electrode connection position on the display substrate in said space.

6. The display device of claim 5, wherein the arrays of first (15;20b) and second (24a) electrodes are interconnected through intermediary anisotropic conductive material (25a;25b).

7. The display device of claim 5 or claim 6, wherein said array of second electrodes (24a) are distributed among a plurality of said wiring substrates (23a;23b) which are individually attachable to said display substrate (12a;12b).

8. The display device of any one of claims 5 to 7, comprising a sign formed on the display substrate, or its associated electrodes, indicating said different electrode connection position.

## Patentansprüche

1. Verfahren zur Leitungsverbindung für eine Anzeigevorrichtung, bei dem eine Anordnung von ersten Elektroden (15; 20b), die auf einem Anzeigesubstrat (12a; 12b) der Anzeigevorrichtung gebildet ist, mit einer entsprechenden Anordnung von zweiten Elektroden (24a), die auf einem Leitungssubstrat (23a; 23b) gebildet ist, durch Durchführen eines Verfahrens verbunden werden, das das Positionieren der Substrate (12a, 23a; 12b, 23b) derart, daß deren Anordnungen einander gegenüberliegen, und das Zusammenbringen der Substrate (12a, 23a) umfaßt, um deren entsprechende erste und zweite Elektroden (15, 24a) miteinander zu verbinden, dadurch gekennzeichnet, daß die Elektrodenverbindungsposition auf dem Anzeigensubstrat (12a) durch einen Zwischenraum von der Kante eines Anzeigenabschnitts (A) des Anzeigensubstrats (12a) beabstandet ist, der ausreichend ist, um, falls nötig, eine Wieder-Verbindung der ersten und zweiten Elektroden in derselben Weise an einer anderen Elektrodenverbindungsposition auf dem Anzeigensubstrat im Zwischenraum zu erlauben.

2. Verfahren nach Anspruch 1, bei dem die früher zusammengebrachten Substrate (12a, 23a) wegen einer nicht normalen Verbindung, die an der anfänglichen Elektrodenverbindungsposition auf dem Anzeigensubstrat (12a) gebildet ist, getrennt werden, und die Substrate (12a, 23a) hinterher wieder zusammengebracht werden, um deren jeweilige erste und zweite Elektroden (15, 24a) an der anderen Elektrodenverbindungsposition auf dem Anzeigensubstrat (12a) miteinander zu verbinden.

3. Verfahren nach Anspruch 1 oder 2, bei dem die Anordnungen der ersten (15; 20b) und zweiten (24a) Elektroden durch ein dazwischenliegendes anisotropisches leitendes Material (25a; 25b) miteinander verbunden sind.

4. Verfahren nach einem der Ansprüche 1 bis 3, bei dem die Anordnung von zweiten Elektroden (24a) auf eine Vielzahl von Leitungssubstraten (23a; 23b) verteilt ist, die einzeln mit dem Anzeigensubstrat (12a; 12b) verbindbar sind.

5. Eine Anzeigenvorrichtung, bei der eine Anordnung von ersten Elektroden (15; 20b), die auf einem Anzeigensubstrat (12a; 12b) der Anzeigenvorrichtung gebildet ist, mit einer entsprechenden Anordnung von zweiten Elektroden (24a) verbunden sind, die auf einem Leitungssubstrat (23a; 23b) gebildet ist, das einem Teil des Anzeigensubstrats gegenüberliegt, dadurch gekennzeichnet, daß die Elektrodenverbindungsposition auf dem Anzeigensubstrat (12a) durch einen Zwischenraum von der Kante eines Anzeigenabschnitts (A) des Anzeigensubstrats (12a) beabstandet ist, der ausreichend ist, um, falls nötig, eine Wieder-Verbindung der ersten und zweiten Elektroden an einer anderen Elektrodenverbindungsposition auf dem Anzeigensubstrat im Zwischenraum zu erlauben.

6. Anzeigenvorrichtung nach Anspruch 5, bei der die Anordnungen der ersten (15; 20b) und zweiten (24a) Elektroden durch ein dazwischenliegendes anisotropisches leitendes Material (25a; 25b) miteinander verbunden sind.

7. Anzeigenvorrichtung nach Anspruch 5 oder 6, bei der die Anordnung von zweiten Elektroden (24a) auf eine Vielzahl von Leitungssubstraten (23a; 23b) verteilt ist, die einzeln mit dem Anzeigensubstrat (12a; 12b) verbindbar sind.

8. Anzeigenvorrichtung nach einem der Ansprüche 5 bis 7, die ein auf dem Anzeigensubstrat oder seinen verbundenen Elektroden gebildetes Zeichen enthält, das die andere Elektrodenverbindungsposition anzeigt.

## Revendications

1. Procédé de connexion de câblage d'un dispositif d'affichage dans lequel un groupe de premières électrodes (15 ; 20b) formées sur un substrat (12a ; 12b) d'affichage dudit dispositif d'affichage sont connectées à un groupe correspondant de deuxièmes électrodes (24a) formées sur un substrat de câblage (23a ; 23b) par une opération consistant à positionner les substrats (12a ; 23a ; 12b ; 23b) avec leurs groupes opposés face à face, et à rapprocher les substrats (12a, 23a) l'un de l'autre pour interconnecter leurs premières et deuxièmes électrodes respectives (15, 24a), caractérisé en ce que la position de connexion des électrodes sur le substrat (12a) d'affichage est espacée du bord d'une section (A) d'affichage du substrat (12a) d'affichage d'un espace qui est suffisant pour permettre, si nécessaire, de reconnecter les premières et deuxièmes électrodes de la même façon dans une autre position de connexion des électrodes sur le substrat d'affichage dans ledit espace.

2. Procédé selon la revendication 1, dans lequel, en raison d'une connexion anormale formée à la position initiale de connexion des électrodes sur le substrat (12a) d'affichage, on écarte les substrats (12a, 23a) préalablement rapprochés, puis on rapproche de nouveau les substrats (12a, 23a) pour interconnecter leurs premières et deuxièmes électrodes respectives (15, 24a) dans ladite autre position de connexion d'électrodes sur le substrat (12a) de l'affichage.

3. Procédé selon la revendication 1 ou la revendication 2, dans lequel les groupes de premières électrodes (15 ; 20b) et deuxièmes électrodes (24a) sont interconnectées par une matière conductrice anisotropique intermédiaire (25a ; 25b).

4. Procédé selon une quelconque des revendications 1 à 3, dans lequel ledit groupe de deuxièmes électrodes (24a) sont réparties en une pluralité desdits substrats de câblage (23a ; 23b) qui peuvent être fixés individuellement audit substrat (12a ; 12b) de l'affichage.

5. Dispositif d'affichage dans lequel un groupe de premières électrodes (15 ; 20b) formées sur un substrat (12a ; 12b) d'affichage du dispositif d'affichage sont connectées à un groupe correspondant de deuxièmes électrodes (24a) formées sur un substrat de câblage (23a ; 23b) qui fait face à une partie du substrat d'affichage, caractérisé en ce que la position de connexion d'électrodes du substrat (12a) d'affichage est espacée du bord d'une section (A) d'affichage du substrat (12a) d'affichage d'un espace qui est suffisant pour permettre, si nécessaire, de reconnecter les premières et deuxièmes électrodes dans une autre position de connexion des électrodes sur le substrat d'affichage dans ledit espace.

6. Dispositif d'affichage selon la revendication 5, dans lequel les groupes de premières électrodes (15 ; 20b) et deuxièmes électrodes (24a) sont interconnectées par une matière conductrice anisotropique intermédiaire (25a ; 25b).

7. Dispositif d'affichage selon la revendication 5 ou la revendication 6, dans lequel ledit groupe de deuxièmes électrodes (24a) sont réparties en une pluralité desdits substrats de câblage (23a ; 23b) qui peuvent être fixés individuellement audit substrat (12a ; 12b) d'affichage.

8. Dispositif d'affichage selon une quelconque des revendications 5 à 7, comprenant un signe formé sur le substrat d'affichage ou sur les électrodes qui lui sont associées, et qui indique ladite autre position de connexion des électrodes.
